# EUROPÄISCHE PATENTANMELDUNG

(11) **EP 4 839 042 A1**
(43) Veröffentlichungstag der Anmeldung: **11.11.2026**
(21) Anmeldenummer: 25175328.1
(22) Anmeldetag: 09.05.2025
(51) Int. Cl.: H05K 9/00

(54) **VORRICHTUNG MIT EINEM ELEKTRISCHEN BAUTEIL UND EINER MAGNETISCHEN ABSCHIRMUNG SOWIE VERFAHREN ZUM ABSCHIRMEN EINES MAGNETFELDS**

(71) Anmelder: Fraunhofer-Gesellschaft zur Förderung der angewandten Forschung e.V., 80686 München (DE)
(72) Erfinder: Koss, Peter, 79110 Freiburg im Breisgau (DE); Busch, Peter, 97082 Würzburg (DE); Schimmerohn, Martin, 79104 Freiburg (DE); Schug, Benedikt, 97082 Würzburg (DE)
(74) Vertreter: WSL Patentanwälte Partnerschaft mbB

(57) **Zusammenfassung**

Die vorliegende Erfindung betrifft eine Vorrichtung mit zumindest einem elektrischen Bauteil oder einem in einem Betrieb der Vorrichtung von elektrischen Ladungsträgern durchströmten Bauteil und einer magnetischen Abschirmung, wobei die magnetische Abschirmung das Bauteil zumindest abschnittsweise umgibt. Erfindungsgemäß wird vorgeschlagen, dass die magnetische Abschirmung ein Substrat aus einem ersten Material und mit einer Oberfläche und mindestens eine auf die Oberfläche aufgebrachte Spritzschicht mit einem von dem ersten Material verschiedenen zweiten Metall oder einer zweiten Metalllegierung oder einer zweiten metallischen Verbindung aufweist.

## Beschreibung

Die vorliegende Anmeldung betrifft eine Vorrichtung mit zumindest einem elektrischen Bauteil oder einem in einem Betrieb der Vorrichtung von elektrischen Ladungsträgern durchströmten Bauteil und einer magnetischen Abschirmung, wobei die magnetische Abschirmung das Bauteil zumindest abschnittsweise umgibt.

Die vorliegende Erfindung betrifft auch eine Verwendung einer Anordnung als magnetische Abschirmung.

Ferner betrifft die vorliegende Erfindung ein Verfahren zum Abschirmen eines Magnetfelds mit den Schritten: Bereitstellen eines elektrischen Bauteils oder eines von Ladungsträgern durchströmten Bauteils und Bereitstellen und Anordnen einer magnetischen Abschirmung, sodass die magnetische Abschirmung das Bauteil zumindest abschnittsweise umgibt.

Aus dem Stand der Technik sind vielfältige Ausführungsformen von magnetischen Abschirmungen bekannt. Diese werden einerseits eingesetzt, um die magnetischen Streufelder von elektrischen Bauteilen oder von mit Ladungsträgern durchströmten Bauteilen abzuschirmen. Andererseits werden magnetische Abschirmungen dazu eingesetzt, elektrische Bauteile oder ladungsträgerdurchströmte Bauteile, die auf magnetische Felder sensitiv reagieren, von Streufeldern aus der Umgebung abzuschirmen.

Aufwändig wird eine solche magnetische Abschirmung immer dann, wenn es gilt, magnetische Wechselfelder, d.h. Magnetfelder mit sich zeitlich ändernder Polarität oder Feldstärke, über einen breiten Frequenzbereich hinweg und ggf. zusätzlich DC-Felder abzuschirmen. Derartig breitbandige magnetische Abschirmungen haben dann einen vergleichsweise großen Platzbedarf.

Für breitbandige Abschirmungen ist man in der Auswahl von Bauformen beschränkt, da sich die zur magnetischen Abschirmung geeigneten Materialien nicht oder nur teilweise in von einfachen Geometrien abweichende Formen bringen lassen.

Demgegenüber ist es eine Aufgabe der vorliegenden Erfindung, eine magnetische Abschirmung bereitzustellen, welche eine kompakte Bauform ermöglicht. Ferner ist es eine Aufgabe der vorliegenden Erfindung, eine magnetische Abschirmung bereitzustellen, welche magnetische Wechselfelder über einen breiten Frequenzbereich hinweg zuverlässig abschirmt. Zudem ist es eine Aufgabe der vorliegenden Erfindung, eine magnetische Abschirmung bereitzustellen, welche sich in komplexen Geometrien herstellen lässt. Darüber hinaus ist es auch eine Aufgabe der vorliegenden Erfindung, eine verglichen mit bekannten Abschirmungen wirksamere magnetische Abschirmung bereitzustellen.

Zumindest eine der zuvor genannten Aufgaben wird erfindungsgemäß durch eine Vorrichtung nach dem unabhängigen Anspruch 1 gelöst. Dazu weist die magnetische Abschirmung der Vorrichtung der eingangs genannten Art ein Substrat aus einem ersten Material und ein mit einer Oberfläche und mindestens eine auf die Oberfläche aufgebrachte Spritzschicht aus einem von dem ersten Material verschiedenen zweiten Metall oder einer zweiten Metalllegierung oder einer zweiten metallischen Verbindung auf.

Es ist die der Erfindung zugrunde liegende Idee, eine magnetische Abschirmung dadurch bereitzustellen, dass eine Spritzschicht aus einem zweiten Metall, einer zweiten Metalllegierung einer zweiten metallischen Verbindung auf die Oberfläche eines Substrats aufgebracht ist. Überraschend hat sich gezeigt, dass solche Spritzschichten eine verbesserte magnetische Abschirmung bereitstellen als dies die entsprechenden Schichten aus Bulkmaterial, beispielsweise einer Folie, vermuten lassen.

Darüber hinaus ist der Einsatz einer Spritzschicht vorteilhaft, da sie sich auf Substrate mit ganz unterschiedlichen Formen und Ausgestaltungen aufbringen lässt. Insbesondere kann eine solche Spritzschicht auf ein Substrat aufgebracht werden, dessen Oberfläche Vorsprünge, d.h. im Wesentlichen konvexe Abschnitte, oder Vertiefungen, d.h. im Wesentlichen konkave Abschnitte, aufweist. Zudem können Spritzschichten auch Kanten und Ecken des Substrats hervorragend abdecken.

Eine solche Spritzschicht wird nach dem vollständigen Fertigen des Substrats als formbestimmendem Grundkörper auf diesen aufgetragen. Daher entstehen in der Spritzschicht keine Spalte, wie sie sich in herkömmlichen magnetischen Abschirmungen als Ursache für "magnetische Lecks" herausgestellt haben.

Ferner erlaubt es die Kombination aus einem Substrat und einer Spritzschicht unterschiedliche magnetisch abschirmende Materialien miteinander zu kombinieren oder eine solche Kombination durch mehr als eine Spritzschicht bereitzustellen.

Zudem können Multi-Layer mit einer Mehrzahl von Spritzschichten mit unterschiedlichen Materialien vergleichsweise einfach hergestellt werden. Jede Spritzschicht adressiert dann eine spezifische Aufgabe. Durch Multi-Layer kann man auch den gesamten Schirmfaktor der Abschirmung erhöhen. Der magnetische Gesamtschirmungsfaktor ist gleich dem Produkt der Schirmungsfaktoren der einzelnen Spritzschichten.

Die einzelnen Spritzschichten können auch auf derselben Fläche mit einer großen Anzahl von Freiheitsgraden aufgetragen werden. Zum Beispiel ist es möglich eine einzige Spritzschicht an einigen Stellen dicker aufzutragen als an anderen. Ferner ist es beispielsweise möglich, Stellen einer Spritzschicht durchlässig für magnetische und/oder elektrische Felder zu gestalten, während andere Stellen der gleichen Spritzschicht undurchlässig sind.

Unter einem elektrischen Bauteil im Sinne der vorliegenden Erfindung wird ein in einem Betrieb der Vorrichtung stromdurchflossenes Bauteil, insbesondere ein Sensor oder ein Aktor, verstanden. Ein Beispiel für ein solches elektrisches Bauteil ist ein Magnetfeldsensor.

Neben den Strömen in elektrischen Bauteilen, die von Magnetfeldern beeinflusst werden oder aber selbst Magnetfelder induzieren, kann eine magnetische Abschirmung auch für ein Bauteil verwendet werden, welches in dem Betrieb der Vorrichtung von elektrischen Ladungsträgern durchströmt ist. Ein Beispiel hierfür ist eine Kathodenstrahlröhre, in der die frei fliegenden Elektronen leicht von einem Magnetfeld abgelenkt werden.

Als erstes Material des Substrats kann eine Vielzahl von Materialien eingesetzt werden, solange sich auf das erste Material eine Spritzschicht, die sich zum Abschirmen eines magnetischen Feldes eignet, aufspritzen lässt. In einer Ausführungsform der Erfindung ist das erste Material ein Kunststoff oder ein erstes Metall oder eine erste Metalllegierung oder eine erste metallische Verbindung.

Ein Metall umfassendes erstes Material für das Substrat weist den Vorteil auf, dass es selbst ebenfalls magnetische Felder abschirmen kann, sodass aus der Kombination des ersten Materials des Substrats und des metallischen Materials der Spritzschicht bereits eine Kombination von Abschirmwirkungen erzielen lässt.

Eine Spritzschicht im Sinne der vorliegenden Erfindung wird auch als gespritzte Schicht bezeichnet. Solche Spritzschichten weisen gegenüber Bulkmaterialien aus dem gleichen Material andere Eigenschaften, insbesondere andere magnetische Eigenschaften, auf.

In einer Ausführungsform der Erfindung ist die Spritzschicht erhältlich durch ein Verfahren des thermischen Spritzens.

Verfahren des thermischen Spritzens sind in der DIN EN 657 definiert. Die Verfahren des thermischen Spritzens sind Oberflächenbeschichtungsverfahren. Dabei werden Spritzpartikel des aufzubringenden Materials (im Sinne der vorliegenden Erfindung des zweiten Metalls, der zweiten Metalllegierung oder der zweiten metallischen Verbindung) in einem Gasstrom beschleunigt und auf die Oberfläche des Substrats geschleudert. In einer Ausführungsform der Erfindung werden dabei die Spritzpartikel ab-, an- oder aufgeschmolzen, wobei dieses Schmelzen bei dem Beschleunigen der Spritzpartikel oder aber beim Auftreffen auf die Oberfläche des Substrats erfolgen kann.

Bei den Verfahren des thermischen Spritzens wird die Oberfläche des Substrats nicht oder nur gering angeschmolzen und daher nur in geringem Maße thermisch belastet. Die Bildung der Spritzschicht findet statt, da die Spritzpartikel beim Auftreffen auf der Oberfläche das Substrats prozess- und materialabhängig mehr oder minder abflachen, vorrangig durch mechanische Verklammerung haften bleiben und lagenweise die Spritzschicht aufbauen. Über die magnetischen Eigenschaften hinaus sind weitere mögliche Qualitätsmerkmale einer Spritzschicht ihre geringe Porosität, ihre feste Anbindung an die Oberfläche des Substrats, ihre Rissfreiheit und ihre homogene Mikrostruktur.

In einer Ausführungsform der Erfindung umfasst das Verfahren des thermischen Spritzens die Schritte: A) Bereitstellen des Substrats, B) Beschleunigen von Partikeln aus dem zweiten Metall oder der zweiten Metalllegierung oder der zweiten metallischen Verbindung in Richtung der Oberfläche, sodass sich die Partikel auf der Oberfläche zu der Spritzschicht anlagern.

In einer Ausführungsform der Erfindung ist das erste Material ein erstes Metall oder eine erste Metalllegierung oder eine erste metallische Verbindung. In einer Ausführungsform der Erfindung ist das erste Metall oder ein Metall der ersten Metalllegierung oder ein Metall der ersten metallischen Verbindung ausgewählt aus einer Gruppe bestehend aus Aluminium, Stahl und Kupfer. In einer Ausführungsform der Erfindung ist die erste Metalllegierung ein Mu-Metall oder Invar.

Unter einem Metall im Sinne der vorliegenden Erfindung wird ein elementares Metall verstanden. Demgegenüber umfassen Metalllegierungen Verbindungen zweier oder mehrerer Metalle. Metallische Verbindungen im Sinne der vorliegenden Erfindung sind insbesondere Keramiken. Solche Magnetkeramiken sind typischerweise Oxidmaterialien, die eine bestimmte Art von Permanentmagnetisierung aufweisen, die als Ferrimagnetismus bezeichnet wird.

In einer Ausführungsform der Erfindung ist das zweite Metall oder ein Metall der zweiten Metalllegierung oder ein Metall der zweiten metallischen Verbindung ausgewählt aus einer Gruppe bestehend aus Aluminium, Stahl und Kupfer. In einer Ausführungsform der Erfindung ist die zweite Metalllegierung ein Mu-Metall oder Invar.

In einer Ausführungsform der Erfindung weist die magnetische Abschirmung eine Mehrzahl von Spritzschichten auf. Dabei ist eine erste Spritzschicht aus der Mehrzahl von Spritzschichten auf die Oberfläche des Substrats aufgebracht, während die nächste Spritzschicht auf die erste Spritzschicht aufgebracht ist.

In einer Ausführungsform der Erfindung ist zumindest eine aus der Mehrzahl von Spritzschichten so gewählt, dass sie zumindest der magnetischen Abschirmung, einer thermischen Isolierung, einer Wärmeleitung, einer mechanischen Stabilisierung oder einem Korrosionsschutz dient.

Durch geeignete Wahl der Materialien der Mehrzahl von Spritzschichten kann eine Mehrschichtstruktur erzeugt werden, die nicht nur im Hinblick auf ihre magnetischen Eigenschaften optimiert ist. Daher ist in einer Ausführungsform der Erfindung zumindest eine aus der Mehrzahl von Spritzschichten so gewählt, dass sie zumindest der magnetischen Abschirmung, einer thermischen Isolierung, einer thermischen Leitung, einer mechanischen Stabilisierung oder einem Korrosionsschutz dient.

In einer Ausführungsform der Erfindung ist eine äußere Spritzschicht der magnetischen Abschirmung als Korrosionsschutz ausgebildet.

In einer Ausführungsform der Erfindung ist zumindest eine Dicke oder eine Materialeigenschaft einer ersten aus der Mehrzahl von Spritzschichten von einer Dicke oder einer Materialeigenschaft einer zweiten aus der Mehrzahl von Spritzschichten verschieden. Dabei ist die Dicke der Spritzschichten senkrecht zur Oberfläche des Substrats gemessen.

Dabei ist eine Materialeigenschaft im Sinne der vorliegenden Erfindung beispielsweise die magnetische Permeabilität, eine elektrische Leitfähigkeit oder eine Sättigungsmagnetisierung.

In einer Ausführungsform weist eine aus der Mehrzahl von Spritzschichten eine hohe relative magnetische Permeabilität, vorzugsweise eine relative magnetische Permeabilität von mehr als 100 und besonders bevorzugt eine relative magnetische Permeabilität von mehr als 1000 auf. Materialien mit hoher relativer magnetischer Permeabilität schirmen Wechselfelder unterhalb einer Frequenz von 10 Hz sowie DC-Felder gut ab.

In einer Ausführungsform der Erfindung weist eine aus der Mehrzahl von Spritzschichten eine hohe elektrische Leitfähigkeit, vorzugsweise von mehr als 10⁶ S/m auf. Materialien mit hoher elektrischer Leitfähigkeit schirmen magnetische Wechselfelder mit Frequenzen von 10 Hz und mehr gut ab.

In einer Ausführungsform der Erfindung weist die Spritzschicht oder zumindest eine aus der Mehrzahl von Spritzschichten eine in einer Richtung parallel zu der Oberfläche des Substrats variierende Dicke auf.

In einer Ausführungsform der Erfindung weist die Oberfläche des Substrats einen im Wesentlichen konkaven Abschnitt, d.h. eine Vertiefung, oder einen im Wesentlichen konvexen Abschnitt, d.h. einen Vorsprung auf. Oberflächen mit konkaven oder konvexen Abschnitten sind Beispiele für komplexe Geometrien des Substrats, die sich mit anderen mehrschichtigen Abschirmungen nur schwer abdecken lassen.

In einer Ausführungsform der Erfindung weist das Substrat eine geometrische Grundform auf, die ein Würfel, ein Quader, eine Kugel oder ein Zylinder ist. Auch eine Kugel oder ein Zylinder weisen eine konvex gekrümmte Oberfläche auf.

In einer Ausführungsform der Erfindung weist die Vorrichtung eine Mehrzahl von abwechselnden Spritzschichten aus dem zweiten Material und einem dritten Metall oder einer dritten Metalllegierung oder einer dritten metallischen Verbindung auf. Dabei ist in einer Ausführungsform das eine Metall Aluminium und die andere Metalllegierung ein Mu-Metall. Mu-Metall weist eine große magnetische Permeabilität auf, während Aluminium eine hohe Leitfähigkeit hat. Eine solche Kombination von Materialien zweier abwechselnd aufgetragener Spritzschichten ermöglicht die magnetische Abschirmung von magnetischen Wechselfeldern über einen großen Frequenzbereich hinweg.

In einer Ausführungsform der Erfindung umfasst das elektrische Bauteil einen Permanentmagneten, wobei das dem elektrischen Bauteil zugewandte Substrat oder die dem elektrischen Bauteil zugewandte Spritzschicht ein Metall oder eine Metalllegierung oder eine metallische Verbindung mit einer Sättigungsmagnetisierung von 1,6 Tesla oder mehr ist. In einer Ausführungsform der Erfindung weist dabei das Metall, die Metalllegierung oder die metallische Verbindung eine Sättigungsmagnetisierung in einem Bereich von 1,6 Tesla bis 2,2 Tesla auf. Ein Material mit einer solch hohen Sättigungsmagnetisierung ermöglicht es, große magnetische Felder, z.B. Felder mit 1 Tesla oder mehr abzuschirmen.

In einer Ausführungsform der Erfindung umfasst die Spritzschicht oder eine aus der Mehrzahl von Spritzschichten in einem ersten Abschnitt das zweite Metall oder die zweite Metalllegierung oder eine metallische Verbindung und in einem zweiten Abschnitt ein drittes Metall, eine dritte Metalllegierung oder die dritte metallische Verbindung, sodass eine Eigenschaft der Spritzschicht in dem zweiten Abschnitt von der Eigenschaft der Spritzschicht in dem ersten Abschnitt abweicht.

Auf diese Weise ist es möglich, in einer einzigen Spritzschicht räumlich verteilt unterschiedliche Eigenschaften bereitzustellen. Auf diese Weise lässt sich beispielsweise eine thermische oder eine elektromagnetische Durchführung durch die Abschirmung realisieren. Dazu ist in einer Ausführungsform der Erfindung die Eigenschaft eine elektromagnetische oder eine thermische Eigenschaft des Materials der Spritzschicht. Eine solche Variation der Eigenschaften der Spritzschicht kann bereits bei einer einzigen Spritzschicht zweckmäßig sein. In einer Ausführungsform jedoch ist eine solche Variation der Eigenschaften über die Fläche hinweg vorgesehen für eine oder mehrerer aus einer Mehrzahl von Spritzschichten.

Darüber hinaus wird zumindest eine der oben genannten Aufgaben auch durch die Verwendung einer Anordnung als magnetische Abschirmung nach dem unabhängigen Anspruch 13 gelöst. Dabei weist die Anordnung ein Substrat aus einem ersten Material und mit einer Oberfläche und mindestens eine auf die Oberfläche aufgebrachte Spritzschicht mit einem zweiten Metall oder einer zweiten Metalllegierung oder einer zweiten metallischen Verbindung auf, wobei das erste Material von dem zweiten Metall oder der zweiten Metalllegierung oder der zweiten metallischen Verbindung verschieden ist.

Ferner wird zumindest eine der oben genannten Aufgaben auch durch ein Verfahren gemäß Anspruch 15 gelöst. Dazu umfasst bei dem Verfahren der oben genannten Art das Bereitstellen der magnetischen Abschirmung weiterhin die Schritte: Bereitstellen eines Substrats aus einem ersten Material und mit einer Oberfläche und Aufspritzen einer Spritzschicht auf die Oberfläche mit einem von dem ersten Material verschiedenen zweiten Metall oder einer zweiten Metalllegierung oder einer zweiten metallischen Verbindung.

Soweit zuvor Aspekte der Erfindung im Hinblick auf die Vorrichtung beschrieben wurden, so gelten diese auch für das Verfahren zum Abschirmen eines Magnetfelds und umgekehrt. Soweit das Verfahren mit einer Vorrichtung gemäß dieser Erfindung ausgeführt wird, so weist diese Vorrichtung die entsprechenden Einrichtungen hierfür auf. Insbesondere sind Ausführungsformen der Vorrichtung zum Ausführen von Ausführungsformen des Verfahrens geeignet.

Weitere Vorteile, Merkmale und Anwendungsmöglichkeiten der vorliegenden Erfindung werden anhand der folgenden Beschreibung einer Ausführungsform und der dazugehörigen Figuren deutlich. Darin sind gleiche Elemente mit identischen Bezugszeichen bezeichnet.
- Figur 1: ist eine schematische Querschnittsansicht einer Ausführungsform der erfindungsgemäßen Vorrichtung.
- Figur 2: ist eine schematische Querschnittsansicht einer Vorrichtung zum Auftragen einer Spitzschicht auf das Substrat der Vorrichtung aus Figur 1.
- Figur 3: ist eine schematische, teilweise weggebrochene Querschnittsansicht einer zweiten Ausführungsform der erfindungsgemäßen Vorrichtung.
- Figur 4: ist eine schematische, teilweise weggebrochene Querschnittsansicht einer dritten Ausführungsform der erfindungsgemäßen Vorrichtung.
- Figur 5: ist eine schematische, teilweise weggebrochene Querschnittsansicht einer vierten Ausführungsform der erfindungsgemäßen Vorrichtung.
- Figur 6: ist eine schematische, teilweise weggebrochene Querschnittsansicht einer fünften Ausführungsform der erfindungsgemäßen Abschirmung.
- Figur 7: ist eine schematische, teilweise weggebrochene Querschnittsansicht einer sechsten Ausführungsform der erfindungsgemäßen Abschirmung.

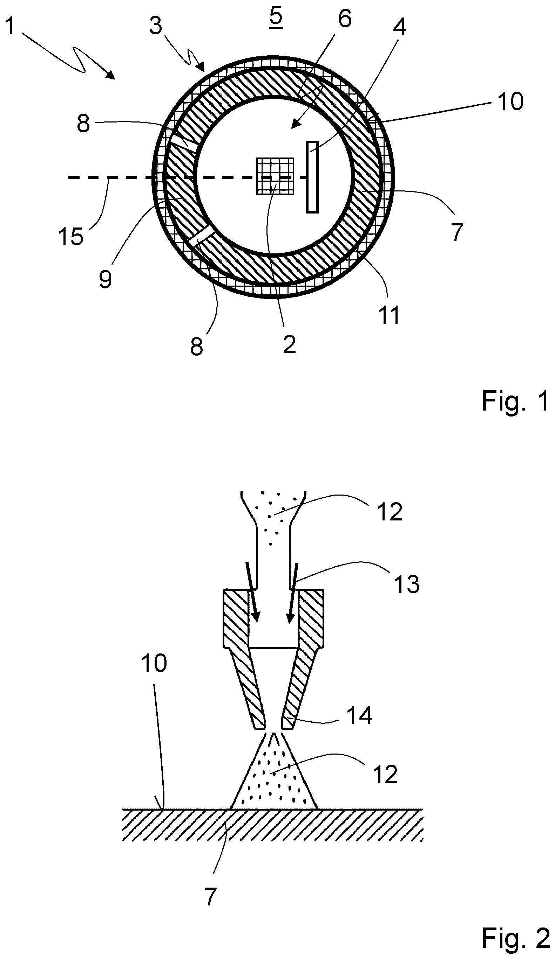

Figur 1 zeigt einen Querschnitt durch eine Ausführungsform einer erfindungsgemäßen Vorrichtung 1. Diese Vorrichtung 1 umfasst ein elektrisches Bauteil sowie eine magnetische Abschirmung 3. In der dargestellten Ausführungsform ist das elektrische Bauteil ein Magnetfeldsensor 2 zur magnetischen Rissprüfung an einem Prüfling 4.

Ein solcher Magnetfeldsensor 2 muss vor Magnetfeldern aus einer Umgebung 5 der Vorrichtung 1 abgeschirmt werden, damit die Messergebnisse des Magnetfeldsensor 2 nicht verfälscht werden. Dazu ist der Magnetfeldsensor 2 in einem Innenraum 6 der magnetischen Abschirmung 3 abgeordnet. Die Abschirmung 3 umgibt den Magnetfeldsensor 2. Bei den abzuschirmenden Magnetfeldern handelt es sich im Wesentlichen um Streufelder von anderen elektrischen Komponenten sowie um das Magnetfeld der Erde. Die abzuschirmenden Magnetfelder sind magnetische Felder mit einer großen Bandbreite an Frequenzen von DC bis über 100 kHz.

Statt der speziellen Ausführungsform eines elektrischen Bauteils könnte ein Bauteil im Innenraum 6 der magnetischen Abschirmung 3 angeordnet sein, das in einem Betrieb der Vorrichtung 1 von elektrischen Ladungsträgern durchströmt ist, beispielsweise ein Kathodenstrahlrohr.

Die hier konkret beschriebenen Anwendungsfälle für die magnetische Abschirmung 3 gehen davon aus, dass der Innenraum 6 der magnetischen Abschirmung 3 vor Störfeldern in der Umgebung 5 der Vorrichtung 1 geschützt werden soll. Umgekehrt ist es aber auch möglich, die in dem Innenraum 6 von einem Bauteil generierten magnetischen Felder abzuschirmen, sodass diese in der Umgebung 5 nicht als Streufelder andere Einrichtungen stören.

In der dargestellten Ausführungsform ist die magnetische Abschirmung 3 kugelförmig, wobei ein Querschnitt der Kugel in Figur 1 gezeichnet ist. Die magnetische Abschirmung 3 umfasst ein Substrat 7 in Form einer kugelförmigen Struktur aus Aluminium. Herstellungsbedingt weist das Aluminium des Substrats 7 Spalte 8 auf, da das Substrat 7 zunächst zweiteilig hergestellt wurde, um ein Einfügen des Sensors 2 bei der Montage zu ermöglichen. Ein Deckel 9 wurde abschließend zum Vervollständigen der Kugel eingesetzt und mit dem restlichen Substrat 7 verschraubt.

Abschließend ist auf eine Oberfläche 10 des Substrats 7 eine Spritzschicht aus einem Mu-Metall aufgebracht. Eine solche Spritzschicht überdeckt insbesondere die Spalte 8 und verhindert ein Lecken der magnetischen Felder durch die magnetische Abschirmung 3.

Das Substrat 7 besteht in der Ausführungsform aus Figur 1 aus Aluminium, während die Spritzschicht 11 aus einer Metalllegierung, nämlich einem Mu-Metall besteht. Das Mu-Metall schirmt Magnetfelder bis zu einer Frequenz von 10 Hz optimal ab. Die Frequenzen welche höher sind als 10 Hz werden vom Aluminium optimal abgeschirmt.

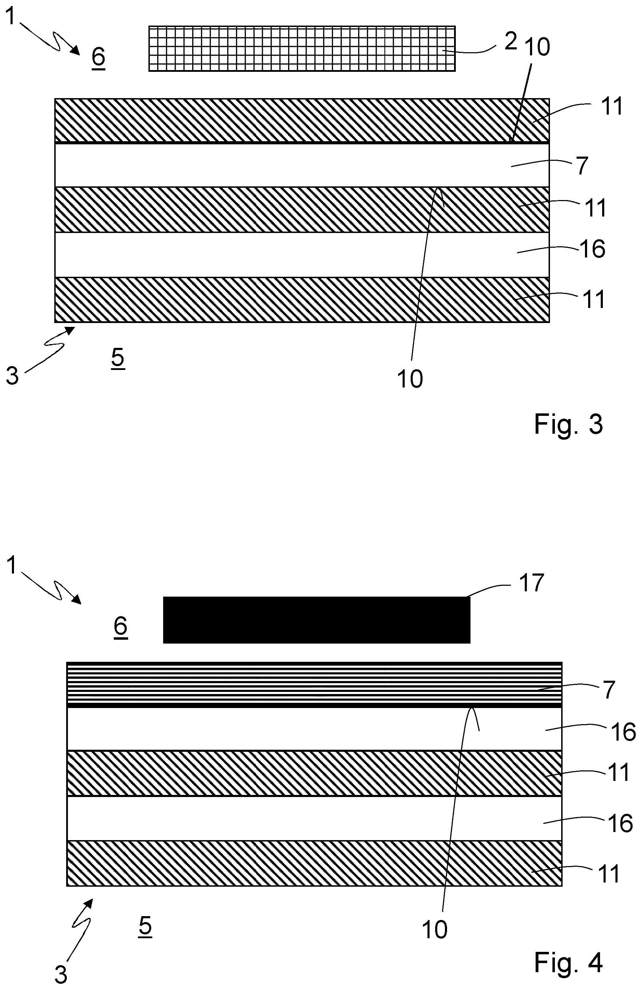

Zudem ist es möglich, Multi-Layer Abschirmungen mit einer Mehrzahl von Spritzschichten herzustellen, so wie sie nachfolgend anhand der Figuren 3 bis 7 beschrieben werden, wobei die einzelnen Spritzschichten unterschiedliche Materialien umfassen.

Das Beispiel eines kugelförmigen Substrats 7, so wie es in Figur 1 schematisch abgebildet ist, zeigt, dass eine entsprechende Abschirmung mit einer komplexen Form aus zwei Lagen aus dem Aluminium des Substrats 7 und einem Mu-Metall der Spritzschicht anderweitig nicht herstellbar ist. Beispielsweise würde eine dünne Mu-Metallfolie, welche man auf das Substrat 7 auflegt d.h. um eine Kugel herumwickelt, Falten und Wellen schlagen. Eine komplexe Form, so wie sie die konvex gekrümmten Oberfläche 10 der Kugel 7 darstellt, könnte mit einer Folie nicht homogen belegt werden. Zudem ließe sich die Folie nicht schließen und es entstünde ein Spalt, der ein Lecken von magnetischen Feldern nach sich zieht.

Figur 2 zeigt schematisch ein Auftragsverfahren für die Spritzschicht 11. Das Mu-Metall für die Spritzschicht 11 aus Figur 1 (oder jedes andere Metall oder andere Metalllegierung oder andere metallische Verbindung) wird in Form eines Pulvers 12 bereitgestellt. Dieses Pulver 12 wird mithilfe eines Gasstroms 13 durch eine Düse 14 in Richtung auf das Substrat 7 hin beschleunigt und auf die Oberfläche 10 des Substrats 7 geschleudert. Eine Schichtbildung findet statt, da die Partikel des Pulvers 12 beim Auftreffen auf die Oberfläche 10 abflachen, durch mechanische Verklammerung haften bleiben und lagenweise die Spritzschicht 11 aufbauen. In der dargestellten Ausführungsform ist das Gas 13 zum Beschleunigen des Pulvers 12 heißer Wasserdampf, sodass die einzelnen Partikel in dem Gasstrom 13 aufgeschmolzen werden.

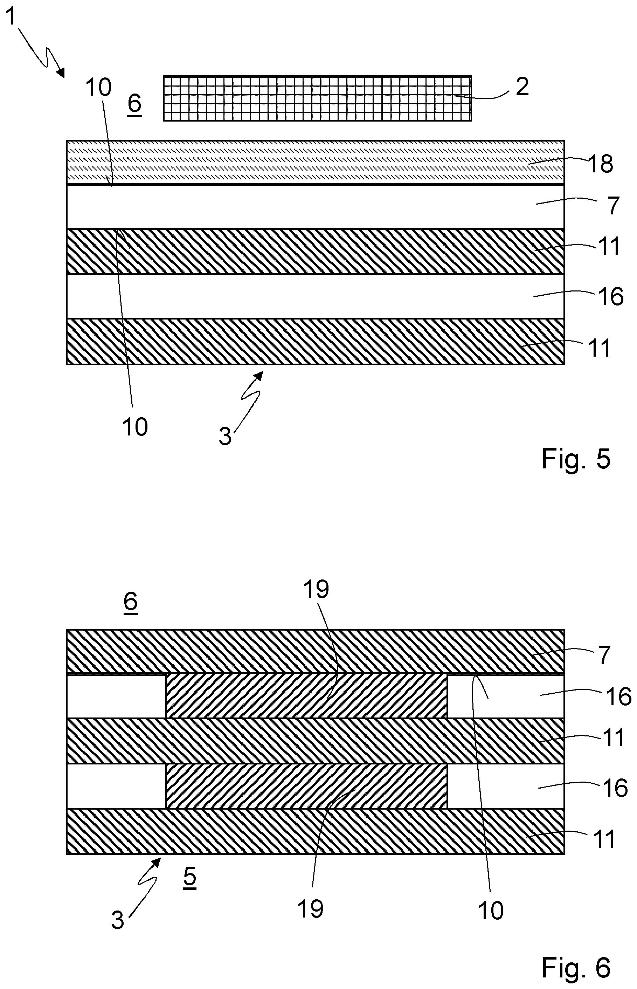

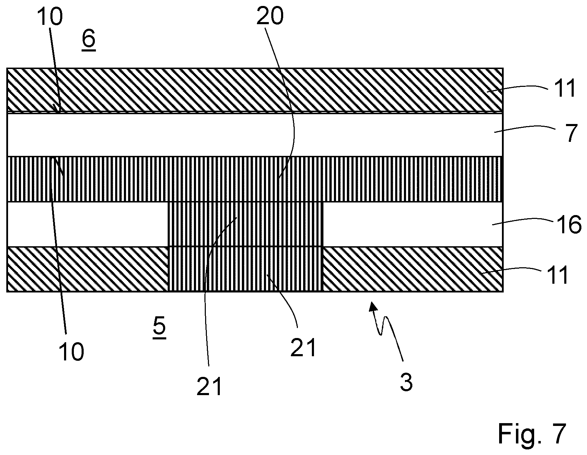

Die Figuren 3 bis 7 zeigen nun verschiedene Varianten von Vorrichtungen 1 (Figuren 3 bis 4) gemäß Ausführungsformen der vorliegenden Erfindung bzw. magnetische Abschirmungen 3 (Figuren 6 und 7) gemäß Ausführungsformen der vorliegenden Erfindung. Dabei sind die Vorrichtungen in teilweise weggebrochenen Querschnittsansichten in Ebenen entlang der Linie 15 und senkrecht zur Zeichenebene aus Figur 1 dargestellt.

In den Beispielen der Figuren 3 und 5 ist das elektrische Bauteil wie zuvor ein Magnetfeldsensor 2. In der Ausführungsform aus Figur 4 ist das elektrische Bauteil ein Elektromotor 17. Das von dem Permanentmagneten des Elektromotors 17 aus Figur 4 ausgehende magnetische Feld wird mithilfe der magnetischen Abschirmung 3 abgeschirmt, sodass es nicht als Streufeld in der Umgebung 5 der Vorrichtung 1 Störungen verursacht.

Figur 3 zeigt einen Aufbau aus einer Mehrzahl von Spritzschichten 11, 16 auf einem Substrat 7. Dabei bestehen das Substrat 7 und die Spritzschicht 16 aus Aluminium und die Spritzschichten 11 wie zuvor aus Mu-Metall. Die Schichtdicken sowohl des Substrats 7 als auch der Spritzschichten 11, 16 können beliebig gewählt werden. In der dargestellten Ausführungsform betragen die Dicken der Spritzschichten 11, 16 jeweils etwa 500 µm, während die Dicke des Substrats etwa 3 mm misst.

In der Ausführungsform aus Figur 4 besteht das Substrat 7 aus Reineisen. Reineisen hat eine hohe Sättigungsmagnetisierung, sodass es auch große magnetische Felder (im gezeigten Beispiel ungefähr 1 T in der Nähe des Magneten des Motors 17) effektiv abschirmt. Die auf das Substrat 7 aus Reineisen aufgebrachten Spritzschichten 11, 16 bestehen wie in Figur 3 aus Mu-Metall 11 und Aluminium 16. Diese Spritzschichten 11, 16 dienen der herkömmlichen Abschirmung von Streufeldern über einen breiten Frequenzbereich.

In der Implementierung aus Figur 5 ist der Magnetfeldsensor 2 vor Störfeldern aus der Umgebung 5 der Vorrichtung 1 abzuschirmen. In dem gezeigten Beispiel ist der Magnetfeldsensor 2 ein optisch gepumptes Magnetometer (OPM), das kleine magnetische Felder bis zu wenigen Femtotesla messen kann. Bei diesen hohen Sensitivitäten kann sogar das Rauschen, welches von der magnetischen Abschirmung 3 selbst ausgeht (thermisches/Johnson-Nyquist-Rauschen) die Messung des Magnetometers 2 stören. Daher wird als erste Spritzschicht 18 nahe am Magnetometer 2 eine Spritzschicht aus einem Material mit einem niedrigen magnetischen Eigenrauschen verwendet. Die übrigen Störfelder, werden wie zuvor aus der geschichteten Anordnung aus Aluminium und Mu-Metall abgeschirmt. In der gezeigten Ausführungsform der Figur 5 sind auf die zwei Oberflächen 10 des Substrats 7 auf beiden Seiten Spritzschichten 11, 18 aufgebracht.

Figur 6 zeigt eine Ausführungsform, bei welcher das Material einer einzigen Spritzschicht über die Oberfläche des Substrats 10 hinweg variiert. Figur 6 zeigt eine Variante mit einer Durchführung durch die Abschirmung 3 für hochfrequente elektromagnetische Signale. Dazu ist in Spritzschichten 16 aus Aluminium ein Abschnitt einer Spritzschicht 19 aus Invar eingebracht. Dieses Füllmaterial lässt lokal hochfrequente elektromagnetische Signale durch die Abschirmung 3 hindurchtreten. Auf diese Weise wird eine Signaldurchführung aus dem Innenraum 6 der Abschirmung in die Umgebung 5 der Vorrichtung 1 bereitgestellt.

In der Ausführungsform aus Figur 7 ist zwischen dem Substrat 7 aus Aluminium und einer Spritzschicht 16 aus Aluminium eine Spritzschicht 20 mit erhöhter thermischer Leitfähigkeit vorgesehen. Um einen Wärmestrom in diese Schicht 20 einleiten zu können, sind die Spritzschichten 11, 16 wie zuvor unterbrochen und als Füllmaterial sind Abschnitte 21 von Spritzschichten mit der gleichen erhöhten thermischen Leitfähigkeit wie der Spritzschicht 20 eingebracht.

Für Zwecke der ursprünglichen Offenbarung wird darauf hingewiesen, dass sämtliche Merkmale, wie sie sich aus der vorliegenden Beschreibung, den Zeichnungen und den Ansprüchen für einen Fachmann erschließen, auch wenn sie konkret nur im Zusammenhang mit bestimmten weiteren Merkmalen beschrieben wurden, sowohl einzeln als auch in beliebigen Zusammenstellungen mit anderen der hier offenbarten Merkmale oder Merkmalsgruppen kombinierbar sind, soweit dies nicht ausdrücklich ausgeschlossen wurde oder technische Gegebenheiten derartige Kombinationen unmöglich oder sinnlos machen. Auf die umfassende, explizite Darstellung sämtlicher denkbarer Merkmalskombinationen wird hier nur der Kürze und der Lesbarkeit der Beschreibung wegen verzichtet.

Während die Erfindung im Detail in den Zeichnungen und der vorangehenden Beschreibung dargestellt und beschrieben wurde, erfolgt diese Darstellung und Beschreibung lediglich beispielhaft und ist nicht als Beschränkung des Schutzbereichs gedacht, so wie er durch die Ansprüche definiert wird. Die Erfindung ist nicht auf die offenbarten Ausführungsformen beschränkt.

Abwandlungen der offenbarten Ausführungsformen sind für den Fachmann aus den Zeichnungen, der Beschreibung und den beigefügten Ansprüchen offensichtlich. In den Ansprüchen schließt das Wort "aufweisen" nicht andere Elemente oder Schritte aus, und der unbestimmte Artikel "eine" oder "ein" schließt eine Mehrzahl nicht aus. Die bloße Tatsache, dass bestimmte Merkmale in unterschiedlichen Ansprüchen beansprucht sind, schließt ihre Kombination nicht aus. Bezugszeichen in den Ansprüchen sind nicht als Beschränkung des Schutzbereichs gedacht.

### Bezugszeichen

- 1: Vorrichtung
- 2: Magnetfeldsensor
- 3: magnetische Abschirmung
- 4: Prüfling
- 5: Umgebung
- 6: Innenraum
- 7: Substrat
- 8: Spalt
- 9: Deckel
- 10: Oberfläche
- 11: Spritzschicht
- 12: Pulver
- 13: Gasstrom
- 14: Düse
- 15: Querschnittsebene der Figuren 3 bis 7
- 16: Spritzschicht
- 17: Elektromotor
- 18: Spritzschicht
- 19: Spritzschicht
- 20: Spritzschicht
- 21: Abschnitt

## Patentansprüche

1. Vorrichtung (1) mit
zumindest einem elektrischen Bauteil (2, 17) oder einem in einem Betrieb der Vorrichtung von elektrischen Ladungsträgern durchströmten Bauteil und
einer magnetischen Abschirmung (3),
wobei die magnetische Abschirmung (3) das Bauteil (2, 17) zumindest abschnittsweise umgibt,
**dadurch gekennzeichnet, dass**
die magnetische Abschirmung (3)
ein Substrat (7) aus einem ersten Material und mit einer Oberfläche (10) und
mindestens eine auf die Oberfläche (10) aufgebrachte Spritzschicht (11) mit einem von dem ersten Material verschiedenen zweiten Metall oder einer zweiten Metalllegierung oder einer zweiten metallischen Verbindung aufweist.

2. Vorrichtung (1) nach dem vorhergehenden Anspruch, wobei die Spritzschicht (11) erhältlich ist durch ein Verfahren des Thermischen Spritzens.

3. Vorrichtung (1) nach dem vorhergehenden Anspruch, wobei das Verfahren des Thermischen Spritzens die Schritte umfasst
A) Bereitstellen des Substrats (7),
B) Beschleunigen von Partikeln (12) aus dem zweiten Metall oder der zweiten Metalllegierung oder der zweiten metallischen Verbindung in Richtung der Oberfläche (10), so dass sich die Partikel auf der Oberfläche (10) zu der Spritzschicht (11) anlagern.

4. Vorrichtung (1) nach einem der vorhergehenden Ansprüche, wobei die magnetische Abschirmung (3) eine Mehrzahl von Spritzschichten (11, 16, 18, 19, 20) aufweist.

5. Vorrichtung (1) nach dem vorhergehenden Anspruch, wobei zumindest eine aus der Mehrzahl von Spritzschichten (11, 16, 18, 19, 20) so gewählt, dass sie zumindest der magnetischen Abschirmung, einer thermischen Isolierung, einer Wärmeleitung, einer mechanischen Stabilisierung oder einem Korrosionsschutz dient.

6. Vorrichtung (1) nach Anspruch 4 oder 5, wobei zumindest eine Dicke oder eine Materialeigenschaft einer ersten aus der Mehrzahl von Spritzschichten (11, 16, 18, 19, 20) von einer Dicke oder einer Materialeigenschaft einer zweiten aus der Mehrzahl von Spritzschichten (11, 16, 18, 19, 20) verschieden ist.

7. Vorrichtung (1) nach einem der vorhergehenden Ansprüche, wobei die Spritzschicht (11, 16, 18, 19, 20) in einer Richtung parallel zu der Oberfläche eine variierende Dicke aufweist.

8. Vorrichtung nach einem der vorhergehenden Ansprüche, wobei die Oberfläche des Substrats einen konkaven oder einen konvexen Abschnitt aufweist.

9. Vorrichtung (1) nach einem der vorhergehenden Ansprüche, wobei die Vorrichtung (1) eine Mehrzahl von abwechselnden Spritzschichten (11, 16, 18, 19, 20) aus dem zweiten Metall, der zweiten Metalllegierung oder der zweiten metallischen Verbindung und einem dritten Metall oder einer dritten Metalllegierung oder einer dritten metallischen Verbindung aufweist, wobei vorzugsweise das eine Metall Aluminium ist und die andere Metalllegierung ein Mu-Metall ist.

10. Vorrichtung (1) nach einem der vorhergehenden Ansprüche, wobei das elektrische Bauteil (2, 17) einen Permanentmagneten umfasst und wobei das dem elektrischen Bauteil (2, 17) zugewandte Substrat (7) oder die dem elektrisch betriebenen Bauteil (2, 17) zugewandte Spritzschicht ein Metall oder eine Metalllegierung oder eine metallische Verbindung mit einer Sättigungsmagnetisierung von 1,6 Tesla oder mehr ist.

11. Vorrichtung (1) nach einem der vorhergehenden Ansprüche, wobei das elektrische Bauteil (2, 17) einen Permanentmagneten umfasst und wobei das dem elektrisch betriebenen Bauteil (2, 17) zugewandte Substrat (7) oder die dem elektrisch betriebenen Bauteil (2, 17) zugewandte Spritzschicht ein Metall oder eine Metalllegierung oder eine metallische Verbindung mit einem magnetischen Eigenrauschen von $10 pT / \sqrt{Hz}$ bei einem Abstand von 1 cm von der magnetischen Abschirmung oder weniger ist.

12. Vorrichtung (1) nach einem der vorhergehenden Ansprüche, wobei die Spritzschicht (2) oder eine aus der Mehrzahl von Spritzschichten (11, 16, 18, 19, 20) in einem ersten Abschnitt das zweite Metall, die zweite Metalllegierung oder die zweite metallische Verbindung und in einem zweiten Abschnitt (21) ein drittes Metall, eine dritte Metalllegierung oder die dritte metallische Verbindung umfasst, so dass eine Eigenschaft der Spritzschicht (19) in dem zweiten Abschnitt von der Eigenschaft der Spritzschicht (16) in dem ersten Abschnitt abweicht.

13. Verwendung einer Anordnung als magnetische Abschirmung (3), wobei die Anordnung ein Substrat (7) aus einem ersten Material und mit einer Oberfläche (10) und mindestens eine auf die Oberfläche (10) aufgebrachte Spritzschicht (11) mit einem zweiten Metall oder einer zweiten Metalllegierung oder einer zweiten metallischen Verbindung aufweist, und wobei das erste Material von dem zweiten Metall oder der zweiten Metalllegierung oder der zweiten metallischen Verbindung verschieden ist.

14. Verfahren zum Abschirmen eines Magnetfelds mit den Schritten
Bereitstellen zumindest eines elektrischen Bauteils (2) oder eines von Ladungsträgern durchströmten Bauteils und
Bereitstellen und Anordnen einer magnetischen Abschirmung (3),
so dass die magnetische Abschirmung (3) das Bauteil (2, 17) zumindest abschnittsweise umgibt,
**dadurch gekennzeichnet, dass**
das Bereitstellen der magnetischen Abschirmung (3) weiterhin die Schritte umfasst
Bereitstellen eines Substrats (7) aus einem ersten Material und mit einer Oberfläche (10) und
Aufspritzen mindestens einer Spritzschicht (11) auf die Oberfläche (10) mit einem von dem ersten Material verschiedenen zweiten Metall oder einer zweiten Metalllegierung oder einer zweiten metallischen Verbindung.
